# EUROPEAN PATENT APPLICATION

(11) **EP 0 824 272 A2**
(43) Date of publication of application: **18.02.1998**
(21) Application number: 97113741.9
(22) Date of filing: 08.08.1997
(51) Int. Cl.: H01L 27/112, H01L 21/8246

(54) **Semiconductor memory and method of producing the same**

(30) Priority: 08.08.1996 JP 209791/96
(71) Applicant: NEC CORPORATION, Tokyo (JP)
(72) Inventor: Tasaka, Kazuhiro, c/o NEC Corporation, Tokyo (JP)
(74) Representative: Betten & Resch

(57) **Abstract**

A semiconductor memory having MOS transistor devices whose gate length is less than half a micron, and a method of producing the same are disclosed. The memory reduces parasitic resistance outside of channels and thereby allows the ON current for the MOS transistors or memory cell transistors to be increased. In addition, the memory guarantees a source-drain withstanding voltage and the reversal threshold voltage of device separating oxide films. The memory can therefore be highly integrated and is reliable.

## Description

### BACKGROUND OF THE INVENTION

The present invention relates to a semiconductor memory and a method of producing the same, particularly a semiconductor memory having MOS (Metal Oxide Semiconductor) transistor devices whose gate length is less than half a micron, and a method of producing the same. More particularly, the present invention is concerned with a mask ROM (Read Only Memory) and a method of producing the same.

Recently, not only semiconductor memories but also semiconductor large scale integrated circuits (LSIs) using MOS transistors have achieved a high degree of integration. However, the problem with an LSI of the type using MOS transistors or gallium-arsenic field effect transistors (GaAs FETs) is that when integration is enhanced to reduce the channel length, an intense electric field is formed in a depletion layer generated in the drain end. The electric field results in a so-called short channel effect, typically a hot electron effect, which renders the operation of the transistors unstable.

In light of the above, a DD (Double Drain) structure or an LDD (Lightly Doped Drain) structure is extensively used with a semiconductor memory device. In this kind of structure, an n⁻ region is provided at the drain end so as to weaken the above electric field in the depletion layer.

However, a semiconductor memory with an LDD structure brings about another problem that sheet resistance particular to the n⁻ region limits an ON current available for memory cell transistors. In the worst case, data written to the memory cannot be read out due to scattering among products. This critically lowers the yield of products. Moreover, when the length of memory cell transistors is increased to meet the increasing demand for large capacity and microconfiguration, the short channel effect becomes conspicuous. This also lowers the source-drain withstanding voltage. In addition, leak between memory cells adjoining each other with the intermediary of a separating region becomes noticeable due to microconfiguration.

### SUMMARY OF THE INVENTION

It is therefore an object of the present invention to provide a semiconductor memory capable of reducing parasitic resistance outside of channels so as to increase an ON current available for memory cell transistors, arid guaranteeing a source-drain withstanding voltage and the reversal threshold voltage of device separating oxide films so as to enhance integration and reliability.

A semiconductor memory of the present invention includes a semiconductor substrate. A plurality of MOS transistor devices are serially connected on the semiconductor substrate, constituting a memory cell group. A memory array has a plurality of memory cell groups adjoining each other with the intermediary of a device separating region extending in the channel direction of the MOS transistor devices, A source-drain region of each MOS transistor device consists of a first doped region in which a first impurity opposite in conductivity type to the semiconductor substrate is diffused, a second doped region in which a second impurity identical in conductivity type with the semiconductor substrate is diffused deeper than in the first doped region so as to surround the first doped region, a third doped region in which a third impurity opposite in conductivity type to the semiconductor substrate is diffused deeper than in the first doped region, but shallower than in the second doped region, and a fourth doped region in which a fourth impurity opposite in conductivity type to the semiconductor substrate is diffused shallower than in the third doped region. The first doped region intervenes between the gate electrode of the MOS transistor device and the fourth doped region such that the fourth doped region is absent beneath the gate electrode. The third doped region intervenes between the first and fourth doped regions and the second doped region. The second doped region surrounds a doped region opposite in polarity to the semiconductor substrate and constituted by the first, third and fourth doped regions.

In accordance with a method of producing a semiconductor memory in which a plurality of MOS transistor devices are serially connected on a semiconductor substrate in the form of a memory cell group, and a memory array has a plurality of memory cell groups adjoining each other with the intermediary of a device separating region extending in the channel direction of the MOS transistor devices, a device separating region for separating the memory cell groups is formed. Then, a gate electrode is formed and shared by the MOS transistor devices while extending in the direction perpendicular to the direction in which the device separating region extends. The surface of the semiconductor device, including the surface of the device separating region and the surface of the gate electrode, is covered with a first insulating film. Subsequently, a first doped region is formed by implanting a first impurity opposite in conductivity type to the semiconductor substrate by ion implantation by using the device separating region and gate electrode as a mask. A second doped region is formed by implanting a second impurity identical in conductivity type with the semiconductor substrate by ion implantation deeper than in the first doped region by using at least the gate electrode as a mask. A third doped region is formed by implanting a third impurity opposite in conductivity type to the semiconductor substrate between the first doped region and the second doped region by ion injection by using the device separating region and gate electrode as a mask. A side wall in the form of a second insulating film is formed on each side of the gate electrode. Further, a fourth doped region is formed by implanting a fourth impurity opposite in conductivity type to the semiconductor substrate by ion implantation shallower than in the third doped region by using the gate electrode, device separating region and side wall as a mask.

### BRIEF DESCRIPTION OF THE DRAWINGS

The above and other objects, features and advantages of the present invention will become apparent from the following detailed description taken with the accompanying drawings in which:
FIG. 1 is a plan view of a conventional NAND type mask ROM;
FIGS. 2A-2E are sections along line A-A of FIG. 1, showing a sequence of steps for producing the mask ROM of FIG. 1;
FIGS. 3A-3E are sections along line B-B of FIG. 1;
FIG. 4A is a section showing a semiconductor memory embodying the present invention;
FIGS, 4B and 4C are sections of the embodiment shown in FIG. 4A;
FIGS. 5A-5G are sections along line A-A of FIG. 4A, showing a sequence of steps for producing the memory of FIG. 4A;
FIGS. 6A-6G are sections along line B-B of FIG. 4A; and
FIGS. 7A-7G are sections showing an alternative embodiment of the present invention.

### DESCRIPTION OF THE PREFERRED EMBODIMENTS

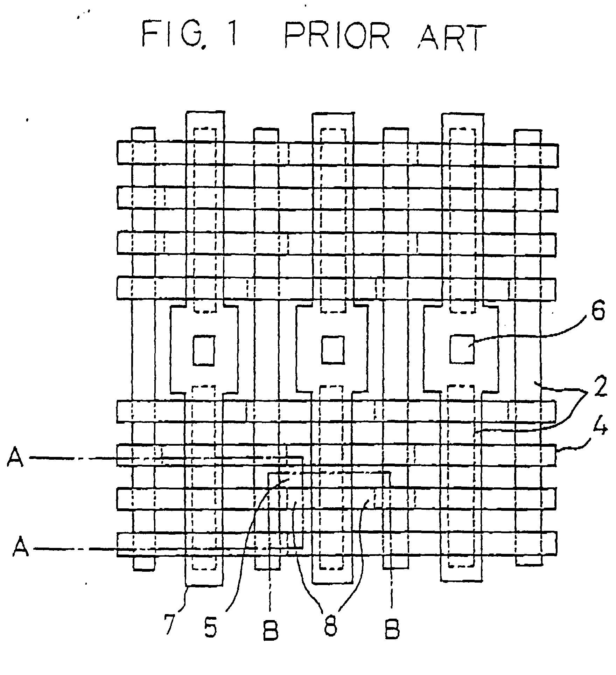

To better understand the present invention, brief reference will be made to a conventional semiconductor memory and a method of producing the same, shown in FIGS. 1, 2A-2G, and 3A-3G. The memory to be described is implemented as a NAND type mask ROM having an LDD structure by way of example.

A mask ROM is an LSI whose contents are determined at the production stage beforehand on the basis of the contents of its memory cell array. Generally, to write data represented by a (logical) ONE (ON) or a (logical) ZERO (OFF) in a mask ROM, MOS transistors are selectively converted form an enhancement type to a depletion type by ion implantation so as to write ONEs therein. As shown in FIG. 1, a NAND type mask ROM has a number of memory cell transistors 5 serially connected in the up-and-down direction, as viewed in FIG. 1, constituting a memory cell group. Nearby memory cell groups are separated by a field oxide film 2. Gate electrodes 4, playing the role of word lines, extend in the right-and-left direction, as viewed in FIG. 1, perpendicularly to the field oxide films 2. To write data in this type of ROM, ions are implanted in the ROM via the apertures of memory cell transistors corresponding to ONEs. The ions transform such memory cell transistors from the enhancement type to the depletion type and thereby short-circuit them.

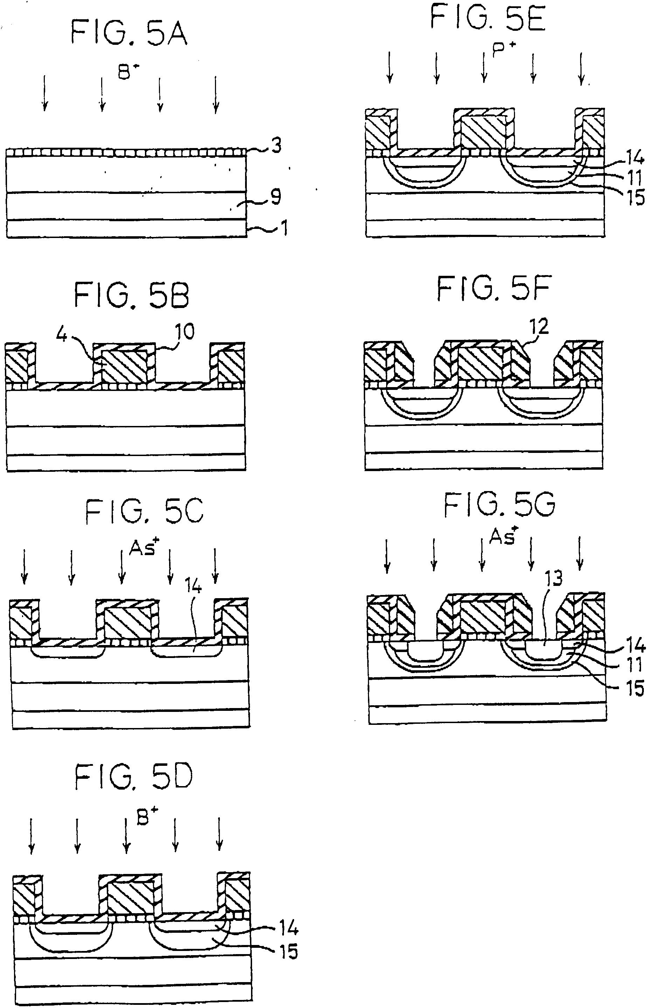

Digit lines 7 are formed on the field oxide films 2. The field oxide films 2 are discontinuous at their portions underlying contact portions 6 included in the digit lines 7. At the contact portions 6, the digit lines 7 are connected to the diffusion regions of the memory cell groups separated by the field oxide films 2. In the specific configuration shown in FIG. 5, four memory cell groups separated by the discontinuous field oxide films 2 are arranged in the form of a letter H around the contact portion of the digit line 7, constituting a memory cell block. A plurality of such generally H-shaped memory cell blocks are arranged in the right-and-left direction, forming a memory array.

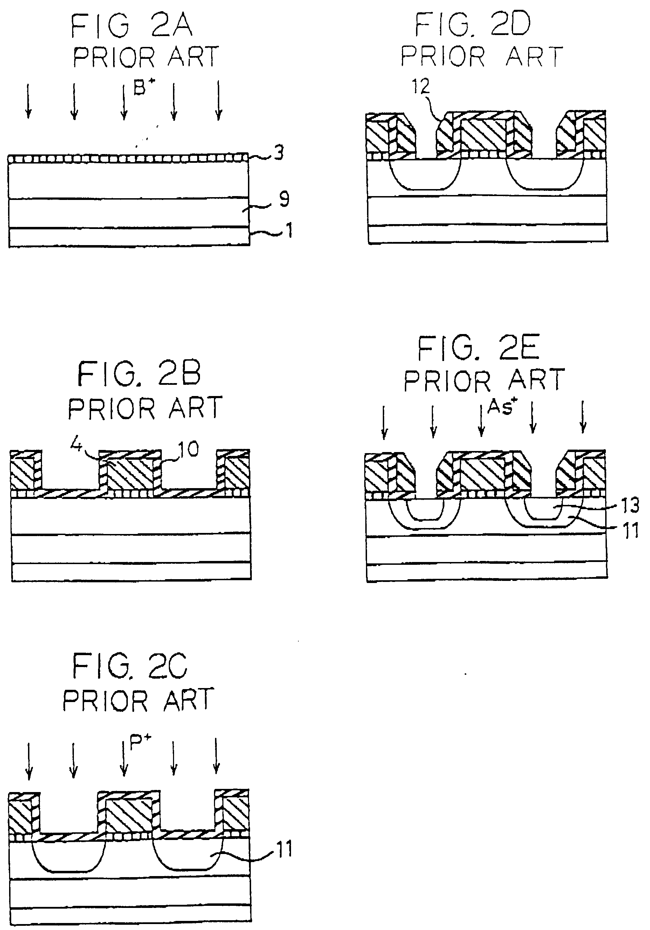

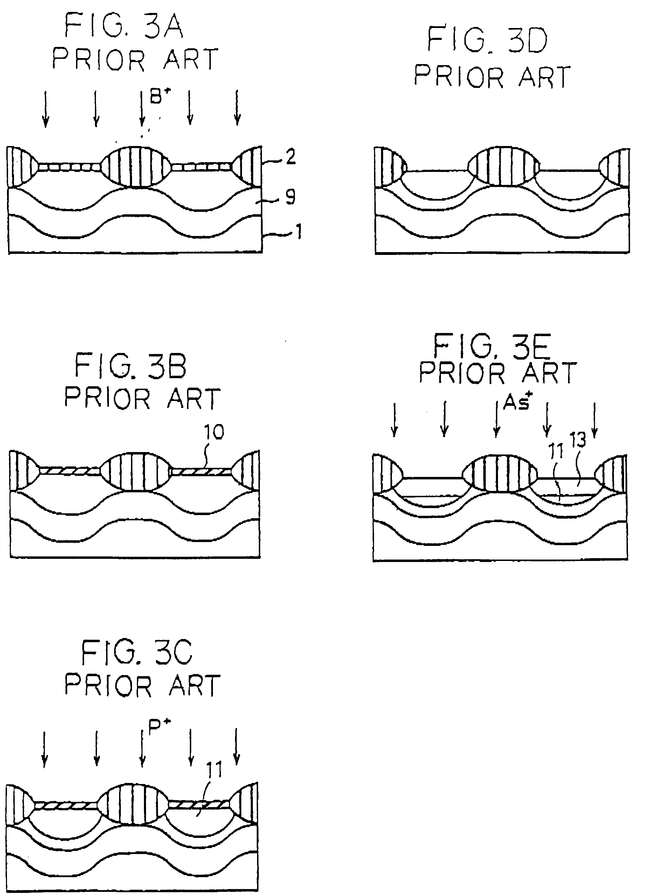

A conventional method of producing a semiconductor device with an LDD structure will be described, taking the above NAND type mask ROM as an example FIGS. 2A-2E and 3A-3E are respectively sections along lines A-A and B-B shown in FIG. 1. First, as shown in FIGS. 2A and 3A, field oxide films 2 are formed on the surface of a *p* type silicone substrate 1 by selective oxidation, and then boron (B⁺) is implanted in the entire surface of the substrate 1 in order to form a retrograde *p* well 9. Subsequently, gate oxide films 3 are formed in the device forming regions separated by the field oxide films 2. Then, gate electrodes 4 are formed on the field oxide films 2 and gate oxide films 3 in the direction perpendicular to the field oxide films 2. Thereafter, a side oxide film 10 is formed on the entire surface, as shown in FIGS. 2B and 3B. Thereafter, phosphor (P⁺) is implanted in order to form n⁻ regions 11, as shown in FIGS. 2C and 3C.

As shown in FIGS. 2D and 3D, an oxide film is deposited on the entire surface of the substrate 1 and then etched back in order to form side walls 12. Thereafter, arsenic (As⁺) is implanted with the gate electrodes 4 and side walls 12 serving as a mask, thereby forming n⁺ regions 13, as shown in FIGS. 2E and 3E.

As shown in FIG. 2E, each memory cell transistor 5 provided with an LDD structure by the above procedure has the n⁻ region 11 surrounding the n⁺ region. Further, as shown in FIG. 3E, each transistor 5 is separated from the adjoining transistors 5 by the field oxide films 2.

After the above procedure, an interlayer film is formed, and then the contact portions 6 are formed, although not shown specifically. As a result, the base configuration of a mask ROM is completed. Apertures 8 are formed, by using resist, right above the memory cell transistors to which ONEs, or ON bits, should be written, on the basis of customer data. Then, phosphor is implanted into such memory cell transistors via the apertures 8 so as to transform them from the enhancement type to the depletion type. Finally, digit lines 7 and a passivation film are formed to complete a mask ROM.

However, the above semiconductor device with an LDD structure has a problem that sheet resistance particular to the n⁻ regions 11 limits an ON current available for memory cell transistors, as stated earlier. In the worst case, data written to the memory cannot be read out due to scattering among products. This critically lowers the yield of products. Moreover, when the length of memory cell transistors is increased to meet the increasing demand for large capacity and microconfiguration, the short channel effect becomes conspicuous. This also lowers the source-drain withstanding voltage Lmin. Further, leak between memory cells adjoining each other with the intermediary of a separating region becomes noticeable due to microconfiguration. Moreover, the distance between the n⁺ layers 13 adjoining each other with the intermediary of the field oxide film 2, as shown in FIG. 3E, is reduced due to microconfiguration. In this condition, the retrograde *p* well 9 cannot reduce the extension of the depletion layer alone, resulting in punch-through.

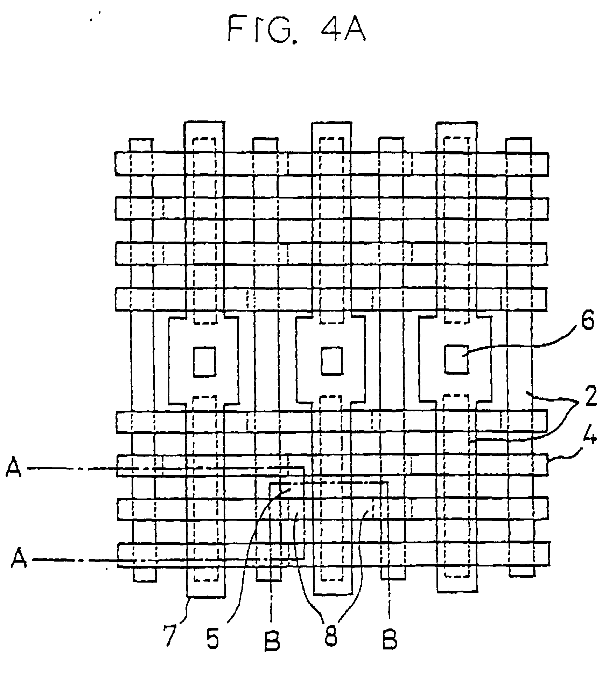

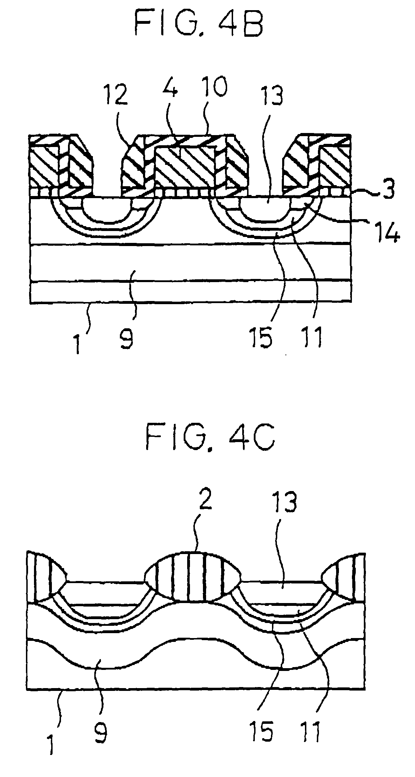

Referring to FIGS. 4A-4C, a semiconductor memory embodying the present invention is shown arid also implemented as a NAND type mask ROM by way of example. As shown in FIG. 4A, the ROM is identical with the conventional ROM shown in FIG. 1 as seen in a plan view. Specifically, the ROM has a number of memory cell transistors 5 serially connected in the up-and-down direction, as viewed in FIG. 4, constituting a memory cell group. Such memory cell groups are separated from each other by field oxide films 2. Gate electrodes 4, playing the role of word lines, are formed in the right-and-left direction, as viewed in FIG. 4, perpendicularly to the field oxide films 2. Digit lines 7 are formed on a part of the field oxide films 2. At contact portions 6 underlying the discontinuous portions of the field oxide films 2, digit lines 7 are connected to the diffusion regions of the memory cell groups separated by the field oxide films 2. Four memory cell groups separated by the discontinuous field oxide films 2 are arranged in the form of a letter H around the contact portion of the digit line 7, constituting a memory cell block. A plurality of such generally H-shaped memory cell blocks are arranged in the right-and-left direction, forming a memory array.

FIG. 4B and 4C are sections showing the memory cell transistors of the above ROM. FIG. 4B is a section along line A-A of FIG. 4A, i.e., in the channel direction of the gate electrodes and source-drain regions FIG. 4C is a section along line B-B of FIG. 4A, i.e., the section of the field oxide films 2 in the source-drain regions and device separating regions.

As shown, each source-drain region formed in a *p* type semiconductor substrate 1 is made up of an *n* layer or first impurity doped region 14, a p⁺ layer or second impurity doped region 15, an n⁻ layer or third impurity doped region, and an n⁺ layer or fourth impurity doped region 13.

In the illustrative embodiment, the *n* layer 14 intervenes between the gate electrode 4 and the n⁺ layer 13 beneath the gate electrode 4. This is contrastive to the conventional structure shown in FIG. 2E. In addition, the *n* doped layer 14 is greater in dose than the n⁺ doped layer 13. It follows that the *n* layer or first doped layer 14 and the n⁺ layer or fourth doped layer 13, implanted deeper than the layer 14, constitute an LDD structure. Also, the *n* layer 14 reduces parasitic resistance outside of the channel, compared to the case wherein the n⁻ layer 11 is provided alone. It is therefore possible to increase the source-drain withstanding voltage Lmin of each memory cell transistor and to increases the ON current of the memory cell transistor.

Moreover, it is noteworthy that the regions opposite in conductivity type to the substrate 1, i.e., the *n* layer 14 and the n⁻ layer 11 and n⁺ layer 13 are surrounded by the p⁺ layer 15, which is implanted deeper than them, both in the channel direction and the direction perpendicular thereto. Stated another way, the p⁺ layer forms a p⁺ diffusion layer surrounding the *n* layer 14 and the n⁻ layer 11 and n⁺ layer 13. In this condition, when a voltage is applied between the source and the drain, a depletion layer is prevented from extending in the channel direction of the n⁻ layer 11. This reduces punch-through and short channel effects and thereby increases the source-drain withstanding voltage Lmin of the memory cell transistor.

Likewise, the p⁺ layer 15 surrounds the n⁺ layer 13 and n⁻ layer beneath the field oxide film 2. Therefore, punch-through is reduced at the position beneath the field oxide film 2 where the gate electrode 4 is absent, so that leak between the nearby memory cells is obstructed more positively. This is particularly desirable when, as shown in FIG. 4A, phosphor ions are implanted via the apertures 8 to transform the nearby memory cell transistors from the enhancement type to the depletion type; leak is apt to occur between the nearby memory cells.

In addition, the n⁻ layer 11 implanted between the n⁺ layer 13 and *n* layer 14 and the p⁺ layer 15 extends the depletion layer therearound, reducing the junction capacitance of the cell.

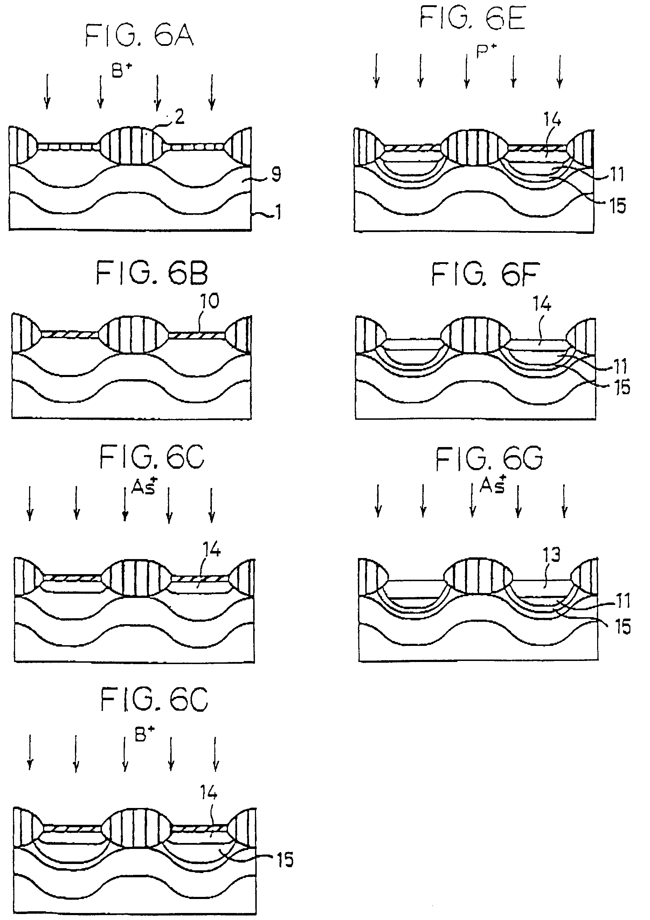

Reference will be made to FIGS. 5A-5G and 6A-6G for describing a method of producing the mask ROM having the above configuration. FIGS. 5A-5G and 6A-6G are respectively sections 6A-6G along lines A-A (channel direction) and B-B (perpendicular to the field oxide films 2). While the substrate 1 may be of either one of *n* type and *p* type, it is assume to be of *p* type in the following description.

First, 0.2 µm to 0.3 µm deep field oxide films 2 are formed on the *p* type semiconductor substrate 1 by selective oxidation, forming device separating regions. The field oxide films 2 each is provided with a width and a distance of about 0.3 µm to 0.4 µm via a mask. Subsequently, boron (B+) which is a *p* type impurity is implanted in the substrate 1 by ion implantation using acceleration energy of 100 keV to 200 keV. As a result, the retrograde well 9 is formed, as shown in FIGS. 5A and 6A. At this instant, a dose ranging from 1 x 10¹³ cm⁻² to 5 x 10¹³ cm⁻² is selected.

Subsequently, 0.008 µm to 0.02 µm thick gate oxide films 3 are formed in the device forming regions separated by the field oxide films 2. The gate electrodes 4 are formed on the field oxide films 2 and gate oxide films 3 in the direction perpendicular to the field oxide films 2. At this instant, the gate electrodes 4 each is provided with a width and a distance of 0.3 µm to 0.4 µm and a thickness of 0.2 µm to 0.3 µm. As shown in FIG. 5B, the gate electrodes 4 each has a double layer structure consisting of tungsten silicide (a specific form of silicide) and polycrystal silicon, i.e., a polycide structure. While each gate electrode 4 may be implemented as a single polycrystal silicon film, the polycide structure is desirable for fine wirings, considering the resistance of wirings.

After the polycide gate electrodes 4 have been formed, the surface of the substrate 1 is treated in a 900°C, dry O₂ atmosphere in order to reduce the layer resistance of the electrodes 4. As a result, as shown in FIGS. 5B and 6B, the side oxide film or first oxide film 10 is formed on the entire surface of the substrate 1 except for the field oxide films 2. The thickness of the side oxide film 10 is selected to be about 0.01 µm to 0.02 µm.

After the step shown in FIGS. 5B and 6B, arsenic (As) is implanted in the substrate 1 as an *n* type impurity or first impurity with the gate electrodes 4 serving as a mask, as shown in FIGS. 5C and 6C. At this instant, the dose of arsenic is 5 x 10¹³ cm⁻² to 1 x 10¹⁵ cm⁻² while the acceleration energy for ion implantation is 50 keV to 70 keV. While a diffusing method other than ion implantation, e.g., thermal diffusion may be used to form the *n* layers 14, ion implantation desirably reduces a junction depth x^{j} for a great dose. Also, while phosphor (P) or similar *n* type impurity may be substituted for arsenic (As), arsenic is preferable in implanting such a great dose to the shallow depth x^{j} and in reducing the layer resistance.

After the *n* layers 14 have been fanned, boron (B+) which is a *p* type impurity or second impurity is implanted in the substrate 1 by acceleration energy of 30 keV to 50 keV with the gate electrodes 4 serving as a mask. The dose of baron is selected to be 3 x 10¹³ cm⁻² to 7 x 10¹³ cm⁻² which is smaller than the dose of arsenic formed the *n* layers 14, As shown in FIGS. 5D and 6D, the resulting p⁺ layers 15 are deeper than the *n* layers 14 and surround the *n* layers 14.

Subsequently, phosphor (P⁺) which is an *n* type impurity or third impurity is implanted in the substrate 1 by acceleration energy of 30 keV to 50 keV with the gate electrodes 4 serving as a mask. The dose of phosphor is substantially the same as the dose of the above boron (3 x 10¹³ cm⁻² to 7 x 10¹³ cm⁻²). Consequently, n⁻ layers 11 are formed between the *n* layers 14 and the p⁺ layers 15, as shown in FIGS. 5E and 6E. It is important that the p⁺ layers 15 surround the *n* layers 14 and n⁻layers 11.

An about 0.05 µm to 0.2 µm thick CVD (Chemical Vapor Deposition) oxide film is deposited on the entire surface of the substrate 1 by CVD and then etched back. As a result, the side walls 12 shown in FIG. 5F are formed. Each side wall 12 is about 0.04 µm to 0.19 µm thick (wide), as measured from the associated gate electrode 4. It is to be noted that CVD refers to atmospheric pressure CVD, low pressure CVD, plasma CVD or the like.

After the walls 12 have been formed, arsenic (As⁺) which is a fourth impurity is implanted in the substrate 1 by acceleration energy of 50 keV to 70 keV with the gate electrodes 4 and side walls 12 serving as a mask. As a result, n⁺ layers or fourth doped regions 13 are formed, as shown in FIGS. 5G and 6G. The dose of arsenic is selected to be 1 x 10¹⁵ cm⁻² to 3 x 10¹⁵ cm⁻² which is greater than the dose of arsenic formed the *n* layer 14. The n⁺ layers 13 are deeper than the *n* layers 14, but shallower than the n⁻ layers 11 and p⁺ layers 15. Consequently, in each source-drain region, the *n* layer 14, n⁺ layer 13 and n⁻ layer 11 are surrounded by the respective p⁺ layer 15, and the layer 14 adjoins the gate electrode 4.

In the above configuration, the *n* layers 14 adjoining the gate electrodes 4 reduce parasitic resistance outside of the channels, compared to the case wherein the n⁻ layers 11 are provided alone. Therefore, an up to about about 1.5 times greater ON current is available for cell transistors.

The p⁺ layers 15 each surrounding the respective *n* layer 14, n⁺ layer 13 and n⁻ layer 11 reduce the extension of the depletion layer. It is therefore possible to reduce in the channel direction, the short channel effect and thereby increase the source-drain withstanding voltage Lmin. It is also possible to reduce punch-through between the memory cell transistors adjoining each other with the intermediary of the field oxide film 2 and ascribable to the extension of the depletion layer, thereby obstructing leak between the cells more positively.

Further, assume that the illustrative embodiment is applied to a mask ROM, particularly a NAND type ROM, and that *n* type ions, e.g., phosphor is implanted in the ON-bit memory cell transistors adjoining each other with the intermediary of the field oxide film 2 via the apertures 8, as shown in FIGs. 4A-4C. Then, punch-through between the phospher-implanted layers can be reduced by the p⁺ layers 15. This stabilizes the operation of the memory and prevents the yield of products from being lowered by high integration.

Moreover, each n⁻ layer 11 intervenes between the associated p⁺ layer 15 and the *n* layer 14 and n⁺ layer 13, causing the depletion layer therearound to extend in the depthwise direction. This reduces the junction capacitance of the memory cell transistor and thereby insures the high speed operation of the mask ROM.

After the above procedure, an interlayer film is formed, and then the contact portions 6 are formed, although not shown specifically. The apertures 8 are formed, by using resist, right above the memory cell transistors to which ONEs, or ON bits, should be written, on the basis of customer data. Then, phosphor or similar *n* type impurity is implanted in such memory cell transistors via the apertures 8 so as to transform them from the enhancement type to the depletion type. Finally, digit lines 7 and a passivation film are formed to complete a mask ROM.

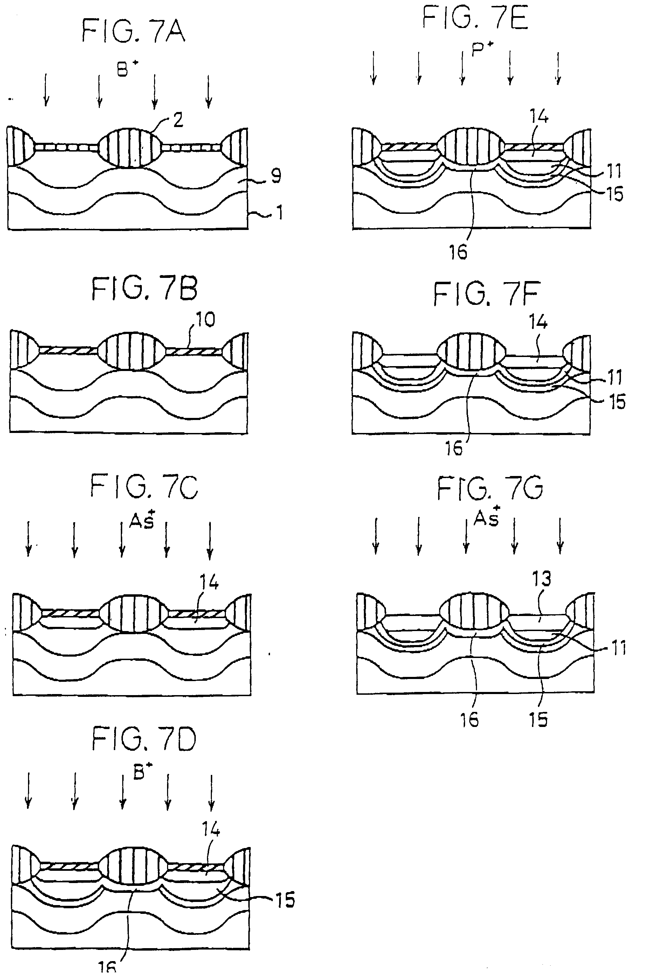

FIGS. 7A-7G show a sequence of steps for producing a semiconductor memory representative of an alternative embodiment of the present invention. This embodiment is similar to the previous embodiment as to the conductivity type of the semiconductor substrate, impurities to be implanted, and procedures for implanting them. FIG. 7D shows a step unique to the alternative embodiment. As shown, when boron (B⁺) is implanted in the substrate 1 in order to form the p⁺ layers 15 with the gate electrodes 4 serving as a mask, it forms a p⁺ layer 16 beneath each field oxide film 2, penetrating the film 2. The p⁺ layer 16 further promotes the obstruction of leak between nearby cells and enhances the yield of products.

In summary, it will be seen that the present invention provides a semiconductor memory and a method of producing the same having various unprecedented advantages, as enumerated below.
(1) First impurity doped regions intervene between fourth impurity doped regions and channels regions and reduce parasitic resistance outside of channels. Therefore, an ON current for cell transistors can be increased in order to obviate defective reading ascribable to the fall of the ON current. This reduces scattering among products and thereby enhances the reliability of operation of the memory and yield.
(2) Second impurity doped regions each surrounding the associated first, third and fourth impurity doped regions reduce the extension of depletion layers at drain ends in the channel direction. This reduces the short channel effect and allows a source-drain withstanding voltage Lmin to be increased. In addition, punch-through ascribable to the extension of a depletion layer is reduced between memory cell transistors adjoining each other with the intermediary of a field oxide film, so that leak between the cells is surely obstructed. Consequently, the memory can be highly integrated.
(3) The third impurity intervening between the second impurity doped regions and the first and fourth impurity doped regions reduces the junction capacitance of the cells. It is therefore possible to realize the high speed operation of the memory and therefore the design of a high speed circuit.
(4) A layer formed beneath each device separating region while penetrating it obstructs leak between nearby memory cells more positively.
(5) The second impurity doped regions reduce punch-through between layers in which, e.g., phosphor is implanted in order to write ON bits in memory cell transistors. Therefore, the memory operates stably when implemented as a mask ROM.
(6) Highly integrated memories can be produced with high yield.

Various modifications will become possible for those skilled in the art after receiving the teachings of the present disclosure without departing from the scope thereof.

## Claims

1. A semiconductor memory comprising:
a semiconductor substrate;
a plurality of MOS transistor devices serially connected on said semiconductor substrate, constituting a memory cell group; and
a memory array comprising a plurality of memory cell groups adjoining each other with the intermediary of a device separating region extending in a channel direction of said plurality of MOS transistor devices;
wherein, a source-drain region of each of said plurality of MOS transistor devices comprises:
a first doped region in which a first impurity opposite in conductivity type to said semiconductor substrate is diffused;
a second doped region in which a second impurity identical in conductivity type with said semiconductor substrate is diffused deeper than in said first doped region so as to surround said first doped region;
a third doped region in which a third impurity opposite in conductivity type to said semiconductor substrate is diffused deeper than in said first doped region, but shallower than in said second doped region; and
a fourth doped region in which a fourth impurity opposite in conductivity type to said semiconductor substrate is diffused shallower than in said third doped region;
wherein said first doped region intervenes between a gate electrode of the MOS transistor device and said fourth doped region such that said fourth doped region is absent beneath said gate electrode, wherein said third doped region intervenes between said first and fourth doped regions and said second doped region, and wherein said second doped region surrounds a doped region opposite in polarity to said semiconductor substrate and constituted by said first, third and fourth doped regions.

2. A memory as claimed in claim 1, wherein said second doped region forms a layer beneath said device separating region, penetrating said device separating region.

3. A memory as claimed in claim 1, wherein said fourth impurity is higher in concentration than said first impurity, wherein said first impurity is higher in concentration than said third impurity, and wherein said third impurity is higher than or equal to said second impurity in concentration.

4. A memory as claimed in claim 1, wherein said semiconductor substrate has *p* type conductivity, wherein said first and fourth impurities comprise arsenic, wherein said second impurity comprises boron, and wherein said third impurity comprises phosphor.

5. A memory as claimed in claim 1, wherein said device separating region comprises a silicon thermal oxide film.

6. A memory as claimed in claim 1, wherein said gate electrode of said MOS transistor device has a polycide structure consisting of silicide and a polycrystal silicon layer.

7. A memory as claimed in claim 1, further comprising a side wall formed of an insulator and provided on each side of said gate electrode of said MOS transistor device, said side wall comprising a silicon oxide film formed by CVD.

8. A memory as claimed in claim 1, wherein said memory comprises a mask ROM.

9. A method of producing a semiconductor memory in which a plurality of MOS transistor devices are serially connected on a semiconductor substrate in a form of a memory cell group, and a memory array has a plurality of memory cell groups adjoining each other with the intermediary of a device separating region extending in a channel direction of said plurality of MOS transistor devices, said method comprising the steps of:
(a) forming a device separating region for separating said plurality of memory cell groups;
(b) forming a gate electrode shared by said plurality of MOS transistor devices and extending in a direction perpendicular to a direction in which said device separating region extends;
(c) covering a surface of said semiconductor device, including a surface of said device separating region and a surface of said gate electrode, with a first insulating film;
(d) forming a first doped region by implanting a first impurity opposite in conductivity type to said semiconductor substrate by ion implantation by using said device separating region and said gate electrode as a mask;
(e) forming a second doped region by implanting a second impurity identical in conductivity type with said semiconductor substrate by ion implantation deeper than in said first doped region by using at least said gate electrode as a mask;
(f) forming a third doped region by implanting a third impurity opposite in conductivity type to said semiconductor substrate between said first doped region and said second doped region by ion injection by using said device separating region and said gate electrode as a mask;
(g) forming a side wall in a form of a second insulating film on each side of said gate electrode; and
(h) forming a fourth doped region by implanting a fourth impurity opposite in conductivity type to said semiconductor substrate by ion implantation shallower than in said third doped region by using said gate electrode, said device separating region and said side wall as a mask.

10. A method as claimed in claim 9, wherein step (e) comprises implanting said second impurity while causing said second impurity to penetrate said device separating region to thereby form a layer beneath said device separating region.

11. A method as claimed in claim 9, wherein said fourth impurity is higher in concentration than said first impurity, wherein said first impurity is higher in concentration than said third impurity, and wherein said third impurity is higher than or equal to said second impurity in concentration.

12. A method as claimed in claim 9, wherein said semiconductor substrate has *p* type conductivity, wherein said first and fourth impurities comprise arsenic, wherein said second impurity comprises boron, and wherein said third impurity comprises phosphor.

13. A method as claimed in claim 9, wherein step (a) uses CVD.

14. A method as claimed in claim 9, wherein step (b) comprises (j) forming a polycide structure consisting of silicide and a polycrystal silicon film.

15. A method as claimed in claim 9, wherein step (g) uses CVD.

16. A method as claimed in claim 9, wherein said semiconductor memory comprises a mask ROM.
